# FASCICULE DE BREVET EUROPEEN

(11) **EP 0 759 631 B1**
(45) Date de publication et mention de la délivrance du brevet: **22.12.1999**
(21) Numéro de dépôt: 96401787.5
(22) Date de dépôt: 13.08.1996
(51) Int. Cl.: H01J 9/02

(54) **Procédé et dispositif de formation de trous dans une couche de matériau photosensible, en particulier pour la fabrication de sources d'électrons**
Verfahren und Vorrichtung zur Herstellung von Löchern in einer Schicht lichtempfindlichen Materials, insbesondere zur Herstellung von Elektronenquellen
Process and apparatus for the fabrication of holes in a layer of photosensitive material, especially for the fabrication of electron sources

(30) Priorité: 17.08.1995 FR 9509879
(43) Date de publication de la demande: 26.02.1997
(73) Titulaire: COMMISSARIAT A L'ENERGIE ATOMIQUE, 75015 Paris Cédex 15 (FR)
(72) Inventeur: Ida, Michel, 38340 Voreppe (FR); Montmayeul, Brigitte, 38190 Brignoud (FR)
(74) Mandataire: Dubois-Chabert, Guy

(56) Documents cités:
- EP-A- 0 338 625
- US-A- 4 377 633
- US-A- 4 857 161
- US-A- 5 277 638
- PATENT ABSTRACTS OF JAPAN vol. 013, no. 282 (M-843), 28 Juin 1989 & JP-A-01 077521 (SEIKO INSTR & ELECTRONICS LTD), 23 Mars 1989
- PATENT ABSTRACTS OF JAPAN vol. 017, no. 302 (P-1553), 10 Juin 1993 & JP-A-05 027104 (RICOH CO LTD), 5 Février 1993

## Description

### Domaine technique

La présente invention concerne un procédé et un dispositif de formation de trous dans une couche de matériau photosensible.

Elle s'applique notamment à la fabrication de sources d'électrons à cathodes émissives à micropointes qui sont utilisées en particulier pour la réalisation de dispositifs de visualisation par cathodoluminescence excitée par émission de champ.

L'invention permet par exemple de fabriquer des écrans plats à micropointes de grande taille, par exemple supérieure à 14 pouces (environ 35 cm), et même des écrans plats à micropointes dont la superficie est voisine de 1 m².

Bien entendu des écrans de taille nettement plus grande peuvent être élaborés grâce à la présente invention.

### Etat de la technique antérieure

Des sources d'électrons à cathodes émissives à micropointes et leurs procédés de fabrication sont décrits par exemple dans les documents (1), (2), (3) et (4) référencés à la fin de la présente description auxquels on peut se reporter.

Pour faciliter la compréhension du problème technique résolu par la présente invention, on -décrit ci-après un exemple connu de procédé de fabrication d'une source d'électrons à cathodes émissives à micropointes.

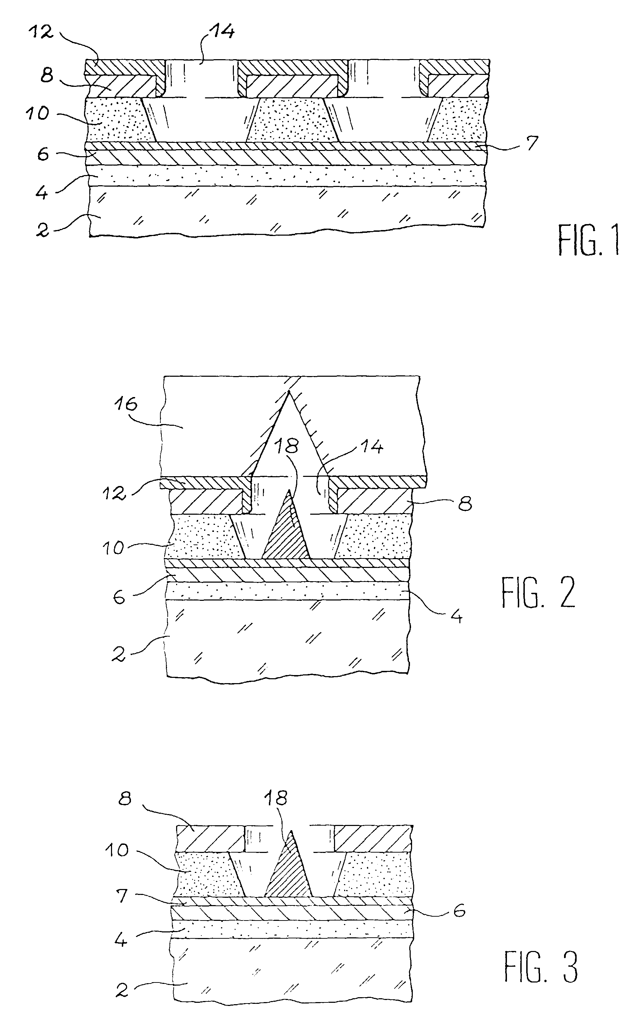

On se référera aux figures 1 à 3 des dessins annexés.

La figure 1 montre une structure déjà élaborée, comprenant, un substrat 2 surmonté d'un isolant 4, un système de conducteurs cathodiques 6, une couche résistive 7 et des grilles 8, superposés sous forme croisée, avec un isolant intermédiaire 10, et une couche 12, par exemple en nickel, déposée en surface pour servir de masque lors d'opérations de réalisation de micropointes.

Cette couche 12 de nickel, les grilles 8 et l'isolant 10 sont percés de trous 14, au fond desquels il s'agit de déposer ultérieurement les micropointes constituées d'un métal conducteur en liaison électrique avec les conducteurs cathodiques 6 à travers la couche résistive 7.

La réalisation des micropointes va maintenant être expliquée en faisant référence à la figure 2.

On commence d'abord par effectuer par exemple le dépôt d'une couche en molybdène 16 sur l'ensemble de la structure.

Cette couche 16 présente une épaisseur d'environ 1,8 µm.

Elle est déposée sous incidence normale par rapport à la surface de la structure.

Cette technique de dépôt permet d'obtenir des cônes 18 en molybdène logés dans les trous 14 et ayant une hauteur de 1,2 à 1,5 µm.

Ces cônes constituent les micropointes émettrices d'électrons.

On réalise ensuite la dissolution sélective de la couche de nickel 12 par un procédé électrochimique, de façon à dégager, comme on le voit sur la figure 3, les grilles perforées 8, par exemple en niobium, et à faire apparaître les micropointes 18 émettrices d'électrons.

A quelques variantes technologiques près, la méthode connue ainsi décrite en se référant aux figures 1, 2 et 3 est une de celles que l'on a appliquées jusqu'à ce jour pour réaliser les micropointes des sources d'électrons à cathodes émissives à micropointes.

Pour que la taille et le positionnement des micropointes 18 soient corrects il faut, bien entendu maîtriser parfaitement la taille des trous réalisés dans les grilles 8 et dans l'isolant 10.

Le problème est donc le suivant :

Il s'agit de réaliser, sur toutes les surfaces devant recevoir des micropointes, des trous dont le diamètre moyen est par exemple de 1,3 µm ou moins.

Les méthodes actuellement utilisées pour réaliser ces trous font appel à des procédés de photolithogravure utilisant la projection directe ou la photorépétition d'un motif élémentaire reproduit sur toutes ces surfaces.

Dans le cas de sources d'électrons de grande taille, supérieure à 14 pouces (environ 35 cm) par exemple, ces procédés deviennent vite très contraignants.

La projection directe nécessite la réalisation d'un masque à l'échelle 1 de grande taille comportant des motifs submicroniques. Ces motifs sont en général composés de métal en couche mince déposé sur un substrat de silice ou de verre.

Ce masque est difficilement réalisable au-dessus de 14 pouces de diagonale avec les techniques classiques utilisées en microélectronique.

En ce qui concerne la photorépétition, on utilise un masque de petite taille, cette taille étant déterminée par la résolution des motifs utilisés.

Pour une résolution de 1 µm, on utilise par exemple un masque de 20 à 50 mm de coté, ce qui oblige à répéter un grand nombre de fois l'opération d'insolation qui est nécessaire à la photolithogravure, pour couvrir la surface totale de la source d'électrons.

Ces deux méthodes (l'une utilisant la projection directe et l'autre la photorépétition) sont donc difficilement applicables à la réalisation de sources d'électrons de grande taille.

Un but de la présente invention est justement de proposer un dispositif et un procédé permettant la formation de trous de façon uniforme sur des grandes surfaces, et ne présentant pas les limitations des méthodes évoquées ci-dessus.

Un autre but est de proposer un procédé et un dispositif permettant de réaliser simultanément tous les trous avec une unique étape d'insolation. Un autre but encore est de proposer un procédé de mise en oeuvre simple, peu coûteuse et adaptée aux exigences des fabrications en série.

Un but de l'invention est également d'appliquer le procédé à la fabrication de sources d'électrons.

### Exposé de l'invention

Pour atteindre ces buts, l'invention a plus précisément pour objet un procédé de formation de trous dans une couche de matériau photosensible, avec une surface libre, disposée sur un empilement, selon lequel on plaque au moyen de forces électrostatiques sur l'ensemble de la surface libre de la couche de matériau photosensible une membrane microperforée, du type membrane de filtration avec des microperforations ; on insole la couche de matériau photosensible à travers la membrane avec une lumière d'insolation de manière à impressionner des zones de la couche photosensible correspondant aux microperforations de la membrane ; on sépare la membrane de la couche de matériau photosensible ainsi insolée, et on développe la couche photosensible pour former dans cette couche des trous correspondant aux zones insolées.

Les membranes microperforées sont disponibles dans le commerce ; il s'agit de membranes du type utilisées pour la filtration.

Ainsi, le procédé de l'invention est moins coûteux que les procédés connus de photolithogravure avec des masques réalisés conformément à des techniques de microélectronique.

Les membranes microperforées sont par ailleurs disponibles en rouleaux de plusieurs mètres ou dizaines de mètres, ce qui permet de traiter de grandes surfaces.

Les microperforations sont selon un aspect de l'invention, réparties aléatoirement sur toute la surface de la membrane avec une densité sensiblement constante. A titre d'exemple, la densité peut aller de quelques milliers à quelques dizaines de milliers de trous par millimètre carré.

Le diamètre des microperforations peut être choisi en fonction de la taille des trous à réaliser. A titre d'exemple, ce diamètre peut être compris entre 0,2 et 20 µm pour les applications envisagées.

La membrane est un matériau non-transparent, de façon à former un masque, et de préférence opaque à la lumière d'insolation utilisée.

Selon un aspect de l'invention, la couche de matériau photosensible peut être une résine. Il est possible dans ce cas d'effectuer un recuit de cette couche pour augmenter sa dureté et éviter d'éventuelles déformations de celle-ci pendant les étapes ultérieures du procédé de l'invention.

L'invention a également pour objet un procédé de fabrication d'une source d'électrons à cathodes émissives à micropointes selon lequel :
- on forme une structure comprenant des conducteurs cathodiques sur un substrat, une couche électriquement isolante sur ces conducteurs cathodiques, et, sur cette couche électriquement isolante, des grilles qui font un angle avec les conducteurs cathodiques,
- dans des domaines où les grilles croisent les conducteurs cathodiques, on forme des trous à travers les grilles et la couche isolante, et
- on forme des micropointes en matériau émetteur d'électrons dans ces trous, sur les conducteurs cathodiques.

Ces trous étant obtenus en formant une couche de résine photosensible positive au moins dans lesdits domaines, à la surface de la structure, en formant des ouvertures (trous) dans la couche de résine conformément au procédé selon la revendication 1 et en gravant les grilles et la couche isolante à travers ces ouvertures formées dans la couche de résine.

L'application du procédé de l'invention à la fabrication des sources d'électrons, en particulier pour des écrans d'affichage est très avantageuse dans la mesure où elle permet de former des masques de résine de grande dimension, et partant, de réaliser des écrans de grande taille. Par ailleurs le procédé est adapté à une fabrication en série de masques de résine.

Une telle fabrication en série est facilitée grâce à un dispositif d'insolation adapté à la mise en oeuvre du procédé.

A cet effet, l'invention concerne aussi un dispositif d'insolation pour la formation de trous dans une couche de matériau photosensible disposée sur un substrat, le dispositif comportant un porte-substrat pour recevoir le substrat avec une couche de matériau photosensible, une bobine de provision de membrane vierge avec des microperforations, et une bobine de réception de membrane après utilisation, les bobines étant agencées de façon à délivrer une portion de membrane vierge tendue entre elles, avec une surface correspondant à la surface de la couche de matériau photosensible, un convoyeur pour déplacer le porte-substrat d'un poste de chargement du substrat vers un poste en face de la portion de membrane vierge, puis vers un poste de déchargement du substrat, des moyens pour plaquer la couche de matériau photosensible contre la portion de membrane vierge puis pour séparer la couche photosensible de cette portion de membrane après une étape d'insolation de la couche photosensible, et une source de lumière d'insolation disposée face à la portion de membrane vierge pour insoler la couche de matériau photosensible à travers les microperforations de la membrane, la membrane étant plaquée sur la couche de matériau photosensible au moyen de forces électrostatiques.

D'autres caractéristiques et avantages de la présente invention ressortiront mieux de la description qui va suivre, en référence aux figures des dessins annexés, donnée à titre purement illustratif et non limitatif.

### Brève description des figures

- les figures 1 à 3, déjà décrites, sont des coupes schématiques partielles illustrant un procédé connu de fabrication d'une source d'électrons à cathodes émissives à micropointes.
- la figure 4 montre, à plus grande échelle, une coupe schématique d'une partie de substrat pour source d'électrons et montre l'insolation de zones d'exposition d'une couche de résine photosensible, conformément à l'invention,
- les figures 5, 6 et 7 illustrent l'invention à l'aide d'un dispositif de formation de trous dans une couche de matériau photosensible et -illustrent des étapes d'un mode d'emploi de ce dispositif.

### Description détaillée des figures

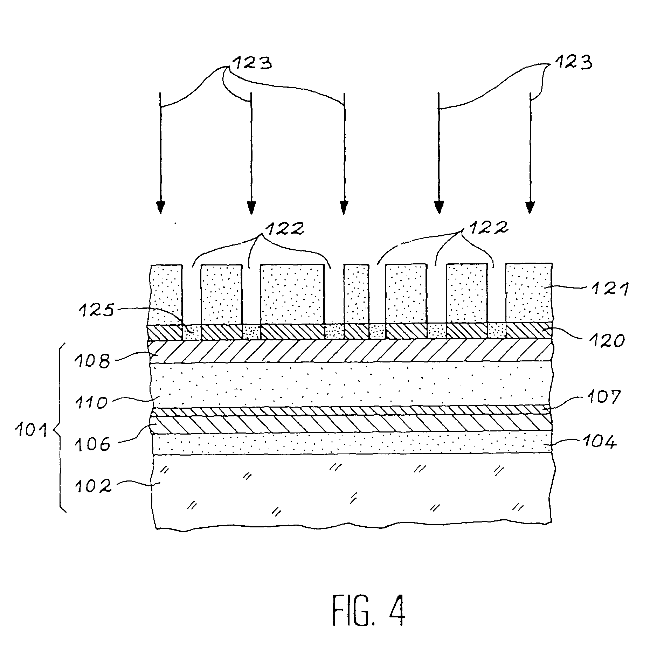

La référence 101 désigne sur la figure 4 un empilement du type utilisé pour la fabrication de sources d'électrons.

Pour des raisons de simplification, des parties de l'empilement 101 qui correspondent à des parties de l'empilement représenté sur les figures 1 à 3 sont désignées par les mêmes références auxquelles on a ajouté 100.

Ainsi, l'empilement 101 comporte un substrat 102, surmonté dans l'ordre d'une couche électriquement isolante 104, d'un système de conducteurs électriques cathodiques 106, d'une couche résistive 107, d'une couche intermédiaire 110, électriquement isolante, et de grilles 108 superposées, sous forme croisée.

On forme à la surface de l'empilement 101, c'est-à-dire au-dessus des grilles 108 un masque de gravure avec des ouvertures qui correspondent à des trous que l'on souhaite pratiquer dans les couches 108 et 110 de l'empilement 101.

Les trous que l'on souhaite pratiquer dans les couches 108 et 110 correspondent aux trous 14 représentés sur la figure 1.

Pour réaliser le masque de gravure, on forme à la surface de l'empilement 101 c'est-à-dire sur la couche 108 une couche de résine photosensible 120 et on y pratique des ouvertures (trous) conformément au procédé de l'invention.

Ainsi, on plaque sur la couche 120 une membrane 121 avec des microperforations 122, on insole la couche de résine photosensible avec une lumière d'insolation 123 pour impressionner des zones 125 de la couche 120 correspondant à des microperforations 122 de la membrane 121, on écarte la membrane 121 et on développe la couche de résine. La membrane 121 est plaquée efficacement sur la couche 120 au moyen de forces électrostatiques.

La membrane 121, qui joue un rôle de masque optique est plaquée sur la couche de résine 120. Ceci permet de recouvrir uniformément cette couche et ainsi éviter toute lumière parasite entre celle-ci et la membrane.

La membrane 121 peut être une membrane de filtration microperforée du type des membranes commercialisées par la Société Whatman en Belgique. Toutefois, tout autre type de membrane peut convenir. Son épaisseur, de quelques micromètres à quelques dizaines de micromètres est choisie de façon adaptée au passage de la lumière dans les microperforations 122.

La membrane 121 peut aussi être fabriquée en irradiant, par exemple, un film de polymère avec des ions lourds avec une énergie de l'ordre de 1 MeV puis en dissolvant les parties du film de polymère qui ont subi une interaction avec le cortège électronique des ions. On peut se reporter à ce sujet aux documents (5) et (6) dont les références sont données à la fin de la présente description.

De façon préférentielle, le matériau de la membrane 121, c'est-à-dire du masque optique, est choisi opaque à la lumière d'insolation 123, de façon à ne laisser passer la lumière d'insolation qu'à travers les microperforations 122. Dans le cas où on utilise un masque optique (membrane) en un matériau qui n'est pas complètement opaque, on peut choisir une résine photosensible dont la vitesse de dissolution lors du développement est beaucoup plus grande dans les zones insolées à travers les microperforations que dans les zones masquées.

La lumière d'insolation, repérée avec la référence 123 provient par exemple d'une source de lumière ultraviolette parallèle (non représentée) disposée de préférence de façon que les rayons atteignent perpendiculairement la surface supérieure de la membrane.

Le temps d'insolation est choisi suffisamment long pour que la couche de résine 120 soit insolée sur toute son épaisseur dans les zones 125.

Après l'insolation, la membrane 121 est retirée de la surface de la couche 120, et cette couche est développée pour y former des trous (ouvertures) dans les zones insolées.

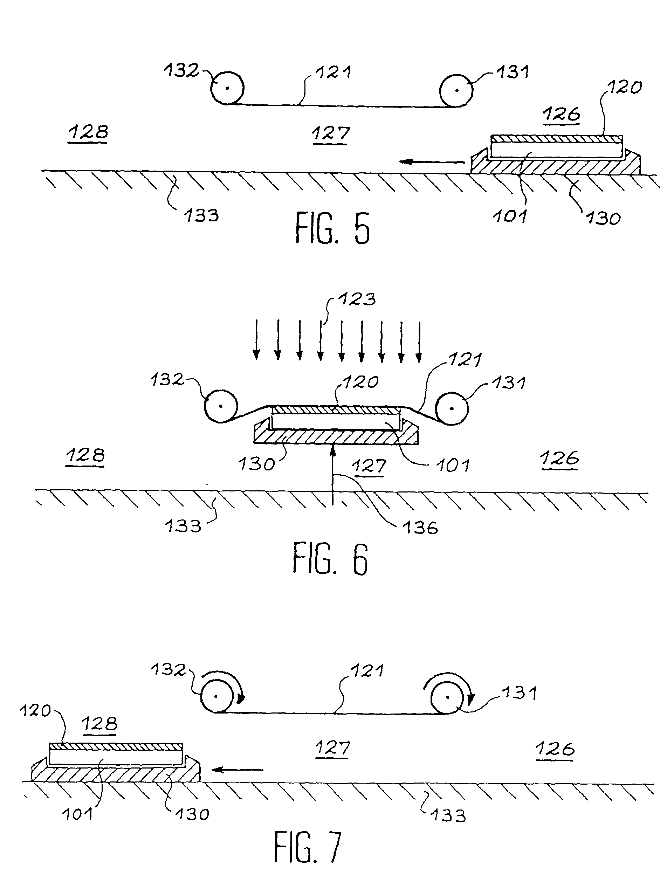

Les figures 5, 6 et 7 montrent un appareillage pour la formation de trous dans une couche de matériau photosensible et illustrent un mode d'emploi. Les parties identiques ou similaires des figures 4, 5, 6 et 7 portent les mêmes références. Il est ainsi possible de se reporter à la description de la figure 4 pour certaines parties correspondantes des figures 5, 6 et 7.

L'appareillage prévu pour la fabrication en ligne comporte, comme le montre la figure 5, une chaîne avec un convoyeur 133 capable de déplacer un échantillon à traiter, successivement d'un poste de chargement 126 vers un poste d'insolation 127 où l'échantillon se trouve en face d'une membrane microperforée 121, puis de ce poste 127 vers un poste de déchargement 128.

L'échantillon à traiter composé d'un empilement 101 recouvert d'une couche de matériau photosensible 120 est disposé sur un porte-substrat 130 au poste de chargement 126.

L'appareillage comporte aussi un système de distribution de membrane vierge pour l'insolation de la couche photosensible 120. Ce système comprend une première bobine 131 de provision avec un rouleau de membrane vierge et une bobine 132 de réception de la membrane après utilisation.

Ce système permet d'utiliser une portion de membrane vierge, c'est-à-dire qui n'a pas subi d'insolation, pour chaque nouvel échantillon à traiter.

Les bobines 131 et 132 sont agencées de façon à tendre entre elles une portion de membrane vierge 121 avec une surface correspondant à la surface de la couche photosensible. La tension de la membrane 121 peut être ajustée pour la plaquer uniformément sur la couche photosensible 120.

Au poste d'insolation sont prévus des moyens de déplacement relatif du porte-substrat 130 perpendiculairement à la membrane 121. Ces moyens sont représentés sur la figure 6 de façon simplifiée par une flèche 136. Il est possible, par exemple, d'utiliser un vérin pneumatique pour soulever le porte-substrat et plaquer ainsi la membrane 121 sur la couche photosensible 120.

La couche 120 est insolée dans cette position par une lumière d'insolation 123 conformément à la description donnée au sujet de la figure 4.

La lumière 123 provient par exemple d'une source d'insolation aux ultraviolets non représentée. L'ensemble de l'appareillage pour la mise en oeuvre du procédé est placé de préférence dans un environnement de lumière inactinique qui n'insole pas la résine de façon parasite.

Comme le montre la figure 7, après l'insolation, la couche 120 est séparée de la membrane 121 en abaissant le porte-substrat 130, et le convoyeur 133 déplace l'ensemble formé par le porte-substrat 130 et le substrat 101 recouvert par la couche 120, vers le poste de déchargement.

Là, le substrat et la couche 120 sont déchargés du porte-substrat et le matériau photosensible de la couche 120 est développé pour former, comme décrit ci-dessus, des trous, ou ouvertures, dans les zones insolées.

La facilité de mise en oeuvre du procédé de l'invention, son faible coût, la possibilité de son intégration dans une chaîne de fabrication en ligne sont autant d'avantages de l'invention qui permettent des applications industrielles très variées.

Comme décrit ci-dessus, le procédé de formation de trous dans une couche de matériau photosensible peut être mis à profit dans la réalisation d'écrans à micropointes, de grande surface.

Une autre application du procédé peut être la réalisation de membranes microperforées sur des substrats de matériaux rigides, tels que des plaquettes de silicium. Celles-ci sont alors gravées à travers un masque avec des trous réalisés conformément à l'invention.

De la même façon, des systèmes optiques gravés, de type antireflet, peuvent être réalisés sur de grandes surfaces.

A titre d'exemple, une couche d'oxyde transparent, par exemple, d'oxyde d'indium-étain (ITO), percée d'une multitude de trous avec un diamètre de l'ordre de 1 µm peut servir de couche antireflet, par exemple, dans des écrans à cristaux liquides. La couche d'ITO est alors gravée avec un masque de matériau photosensible dans lequel des trous (ou ouvertures) sont réalisés conformément à l'invention.

### DOCUMENTS CITES DANS LA PRESENTE DESCRIPTION

*(****1****)*
   FR-A-2 593 953 (voir aussi EP-A-0 234 989)
*(****2****)*
   US-A-4 857 161
*(****3****)*
   FR-A-2 663 462
*(****4****)*
   FR-A-2 687 839 (voir aussi EP-A-0 558 393)
*(****5****)*
   "Production and application of nuclear track micro-filters" de P. VATER - Nuclear Track Radiat. meas., vol. 15, n°1-4, pp. 743-749, 1988
*(****6****)*
   "Ion Tracks and Microtechnology principles and applications" de Reimar Spohr, édited by Klaus Bethge.

## Revendications

1. Procédé de formation de trous dans une couche de matériau photosensible (120), avec une surface libre, disposée sur un empilement (101), selon lequel on plaque au moyen de forces électrostatiques sur l'ensemble de la surface libre de la couche de matériau photosensible (120) une membrane microperforée du type membrane de filtration avec des microperforations (122) ; on insole la couche de matériau photosensible (120) à travers la membrane (121) avec une lumière d'insolation (123) de manière à impressionner des zones (125) de la couche photosensible (120) correspondant aux microperforations (122) de la membrane (121) ; on sépare la membrane (121) de la couche de matériau photosensible (120) ainsi insolée, et on développe la couche photosensible (120) pour former dans cette couche des trous correspondant aux zones insolées (125).

2. Procédé selon la revendication 1, caractérisé en ce qu'on utilise une membrane (121) en un matériau opaque à la lumière d'insolation (123).

3. Procédé selon l'une quelconque des revendications précédentes, caractérisé en ce qu'on utilise une membrane (121) avec des microperforations (122) réparties aléatoirement et avec une densité sensiblement constante.

4. Procédé selon l'une quelconque des revendications précédentes, caractérisé en ce qu'on utilise une membrane (121) avec des microperforations (122) présentant un diamètre compris entre 0,2 et 20 µm.

5. Procédé selon l'une quelconque des revendications précédentes, caractérisé en ce que le matériau photosensible est une résine photosensible et en ce que l'on effectue un recuit de la couche de matériau photosensible (120) avant de plaquer sur celle-ci la membrane microperforée (121).

6. Procédé de fabrication d'une source d'électrons à cathodes émissives à micropointes selon lequel :
- on forme une structure comprenant des conducteurs cathodiques (106) sur un substrat (102), une couche électriquement isolante (110) sur ces conducteurs cathodiques, et, sur cette couche électriquement isolante, des grilles (108) qui font un angle avec les conducteurs cathodiques,
- dans des domaines où les grilles (108) croisent les conducteurs cathodiques (106), on forme des trous à travers les grilles et la couche isolante (110), et
- on forme des micropointes en matériau émetteur d'électrons dans ces trous, sur les conducteurs cathodiques,
ces trous étant obtenus en formant une couche de résine photosensible positive (120) au moins dans lesdits domaines, à la surface de la structure, en formant des ouvertures dans la couche de résine conformément au procédé selon la revendication 1 et en gravant les grilles et la couche isolante à travers ces ouvertures formées dans la couche de résine.

7. Dispositif d'insolation pour la formation de trous dans une couche de matériau photosensible disposée sur un substrat, le dispositif comportant un porte-substrat (130) pour recevoir le substrat (101) avec une couche de matériau photosensible (120), une bobine (131) de provision de membrane vierge (121) avec des microperforations, et une bobine (132) de réception de membrane après utilisation, les bobines (131, 132) étant agencées de façon à délivrer une portion de membrane vierge (121) tendue entre elles, avec une surface correspondant à la surface de la couche de matériau photosensible, un convoyeur (133) pour déplacer le porte-substrat (130) d'un poste (126) de chargement du substrat vers un poste (127) en face de la portion de membrane vierge, puis vers un poste (128) de déchargement du substrat, des moyens pour plaquer la couche de matériau photosensible contre la portion de membrane vierge puis pour séparer la couche photosensible de cette portion de membrane après une étape d'insolation de la couche photosensible, et une source de lumière d'insolation (123) disposée face à la portion de membrane vierge (121) pour insoler la couche de matériau photosensible (120) à travers les microperforations de la membrane, la membrane (121) étant plaquée sur la couche de matériau photosensitive (120) au moyen de forces électrostatiques.

## Patentansprüche

1. Verfahren zur Herstellung von Löchern in einer Schicht lichtempfindlichen Materials (120) mit einer freien Oberfläche auf einem Stapel (101), nach dem auf der gesamten freien Oberfläche der Schicht aus lichtempfindlichem Material (120) eine mikroperforierte Membran (121) des Typs Filtrationsmembran mit Mikroperforationen (122) durch elektrostatische Kräfte angedrückt wird; man die Schicht lichtempfindlichen Materials (120) durch die Membran (121) hindurch mit einem Bestrahlungslicht (123) bestrahlt, um Zonen (125) der lichtempfindlichen Schicht (120) zu belichten, die den Mikroperforationen (122) der Membran (121) entsprechen; man die Membran (121) von der derart bestrahlten Schicht lichtempfindlichen Materials (120) trennt und die lichtempfindliche Schicht (120) entwickelt, um in dieser Schicht Löcher zu bilden, die den bestrahlten Zonen (125) entsprechen.

2. Verfahren nach Anspruch 1, dadurch gekennzeichnet, daß man eine Membran (121) aus einem Material benutzt, das für das Bestrahlungslicht (123) undurchlässig ist.

3. Verfahren nach einem der vorangehenden Ansprüche, dadurch gekennzeichnet, daß man eine Membran (121) mit Mikroperforationen (122) benutzt, die zufällig und mit einer im wesentlichen gleichmäßigen Dichte verteilt sind.

4. Verfahren nach einem der vorangehenden Ansprüche, dadurch gekennzeichnet, daß man eine Membran (121) mit Mikroperforationen (122) benutzt, die einen zwischen 0,2 und 20µm enthaltenen Durchmesser aufweisen.

5. Verfahren nach einem der vorangehenden Ansprüche, dadurch gekennzeichnet, daß das lichtempfindliche Material ein lichtempfindliches Resist ist, und dadurch, daß man ein Tempern der Schicht aus lichtempfindlichem Material (120) durchführt, ehe man auf dieser die mikroperforierte Membran (121) anbringt.

6. Verfahren zur Herstellung einer Elektronenquelle mit Mikrospitzen-Emissionskathoden mit folgenden Schritten:
- man bildet eine Struktur, die Kathodenleiter (106) auf einem Substrat (102), eine elektrisch isolierende Schicht (110) auf diesen Kathodenleitern und, auf dieser elektrisch isolierenden Schicht, Gitter (108) umfaßt, die mit den Kathodenleitern einen Winkel bilden,
- man bildet Löcher in den Bereichen, wo die Gitter (108) die Kathodenleiter (106) kreuzen, durch die Gitter und die Kathodenleiter (110) hindurch, und
- man bildet Mikrospitzen aus elektronenemittierendem Material in diesen Löchern, auf den Kathodenleitern,
wobei diese Löcher hergestellt werden, indem man wenigstens in den genannten Bereichen eine Schicht aus lichtempfindlichem Positivresist (120) bildet, auf der Oberfläche der Struktur, indem man in der Resistschicht Öffnungen gemäß dem Verfahren nach Anspruch 1 bildet und indem man die Gitter und die Isolierschicht durch diese Öffnungen hindurch in der Resistschicht bildet.

7. Bestrahlungsvorrichtung zum Herstellen der Löcher in einer Schicht lichtempfindlichen Materials, angebracht auf einem Substrat, umfassend einen Substratträger (130), um das Substrat (101) mit einer Schicht lichtempfindlichen Materials (120) aufzunehmen, eine Spule (131) zur Versorgung mit neuer Membran (132) und eine Spule (132) zur Aufnahme der gebrauchten Membran, wobei die Spulen (131, 132) so angeordnet sind, daß sie ein zwischen ihnen gespanntes Teilstück der neuen Membran (121) liefern, dessen Fläche der Fläche der Schicht aus lichtempfindlichem Material entspricht, ein Förderband (133) zum Verschieben des Substratträgers (130) von einer Ladestation (126) des Substrats zu einer Station (127) gegenüber dem neuen Membranteilstück, dann zu einer Entladestation (128) des Substrats, Einrichtungen zum Andrücken des lichtempfindlichen Materials gegen das neue Membranteilstück, dann zum Trennen der lichtempfindlichen Schicht von diesem Mebranteilstück nach einem Bestrahlungsschritt der lichtempfindlichen Schicht, und eine Bestrahlungslichtquelle (123), dem neuen Membranteilstück (121) gegenüber angeordnet, um die lichtempfindliche Schicht (120) durch die Mikroperforationen der Membran hindurch zu bestrahlen, wobei die Membran (121) durch elektrostatische Kräfte auf die Schicht aus lichtempfindlichem Material (120) gedrückt wird.

## Claims

1. Method for forming holes in a layer (120) of photosensitive material, with a free surface, arranged on a stack (101), according to which by means of electrostatic forces a micro-perforated membrane of the type used for filtration with micro-perforations (122) is laid onto the entire free surface of the layer (120) of photosensitive material; the layer (120) of photosensitive material is insolated through the membrane (121) with insolation light (123) so as to print areas (125) of the photosensitive layer (120) corresponding to the micro-perforations (122) of the membrane (121); the membrane (121) is separated from the thus insolated layer (120) of photosensitive material (120) and the photosensitive layer (120) is developed in order to form holes corresponding to the insolated areas (125) in this layer.

2. Method according to claim 1, characterized in that a membrane (121) made of a material opaque to the insolation light (123) is used.

3. Method according to either of the preceding claims, characterized in that a membrane (121) is used with randomly distributed micro-perforations (122) at a substantially constant density.

4. Method according to any one of the preceding claims, characterized in that a membrane (121) is used having micro-perforations (122) with a diameter between 0.2 and 20 µm.

5. Method according to any one of the preceding claims, characterized in that the photosensitive material is a photosensitive resin and that annealing of the layer of photosensitive material (120) is carried out before the micro-perforated membrane (121) is laid onto it.

6. Method for the manufacture of a source of micro-point cathode electrons in accordance with which:
- a structure including cathode conductors (106) is formed on a substrate (102), an electrically insulating layer (110) is formed on the cathode conductors, and, grids (108) are formed on the electrically insulating layer which make an angle with the cathode conductors,
- holes are formed through the grids and the insulating layer (110) in areas where the grids (108) cross the cathode conductors (106),
- micro-points of electron emitting material are formed in these holes, on the cathode conductors,
said holes being obtained by forming a positive layer (120) of photosensitive resin at least in said areas, at the surface of the structure, by forming openings in the layer of resin in accordance with the method according to claim 1 and by etching the grids and the insulating layer through these openings formed in the resin layer.

7. Insolation device for the formation of holes in a layer of photosensitive material arranged on a substrate, the device comprising a substrate carrier (130) to receive the substrate (101) with a layer (120) of photosensitive material, a supply spool (131) of blank membrane (121) with micro-perforations and a spool (132) for receiving the membrane after use, the spools (131, 132) being laid out in such a way that a portion of blank membrane (121) is supplied, stretched between them, having a surface area corresponding to the area of the layer of photosensitive material, a conveyor (133) for moving the substrate carrier (130) from a substrate loading position (126) to a position (127) opposite the portion of blank membrane, and then to a substrate unloading position (128), the means for laying the layer of photosensitive material against the blank material and then for separating the photosensitive layer from this portion of membrane after a step of insolation of the photosensitive layer, and a source (123) of insolation light positioned opposite the portion of blank membrane (121) for insolating the layer of photosensitive material (120) through the micro-perforations of the membrane, the membrane (121) being engaged on the photosensitive material layer (120) by means of electrostatic forces.
